(19) Europäisches Patentamt
European Patent Office
Office européen des brevets

(11) EP 0 704 881 A2

(12) EUROPEAN PATENT APPLICATION

(43) Date of publication:
03.04.1996 Bulletin 1996/14

(51) Int. Cl.$^6$: H01J 61/35, H01J 61/82,
H01J 61/86, H01J 61/54

(21) Application number: 95115245.3

(22) Date of filing: 27.09.1995

(84) Designated Contracting States:
DE NL

(30) Priority: 27.09.1994 JP 256088/94
27.09.1994 JP 256089/94

(71) Applicant: USHIODENKI KABUSHIKI KAISHA
Chiyoda-ku, Tokyo 100 (JP)

(72) Inventors:
• Inoue, Osamu
Himeji-shi, Hyogo-ken (JP)
• Yamamoto, Yusuke
Himeji-shi, Hyogo-ken (JP)

(74) Representative: Weber, Otto Ernst, Dipl.-Phys. et al
Weber & Heim
Irmgardstrasse 3
D-81479 München (DE)

(54) Discharge lamp

(57) A discharge lamp in which a metal or metal compound which condenses at low temperatures of an arc tube (1) is rapidly vaporized to a sufficient degree to shorten lamp warm-up time, and at the same time, the degree of illumination is increased by the fact that the arc tube (1) is provided with doping layers (7) for purposes of transmission of visible radiation and a value of a ratio T2/T1 is set in the range from $8.0 \times 10^{-3}$ to $6.0 \times 10^{-1}$, where T1 is the thickness of the arc tube in micrometers and T2 is a weight ratio of the dopant in the doping layers (7) with respect to the weight of the arc tube in ppm. This result can also be achieved by coating layers (7) applied to the outside surface of the arc tube (1) with the value of T2/T1 being set in the range from $8.0 \times 10^{-4}$ to $4.0 \times 10^{-2}$. The dopant and the coating material can be formed of a combination of silicon dioxide ($SiO_2$) and cerium dioxide ($CeO_2$), a combination of silicon dioxide ($SiO_2$) and titanium dioxide ($TiO_2$), or the like.

Fig. 1

EP 0 704 881 A2

## Description

### Background of the Invention

### Field of the Invention

The invention relates to a discharge lamp, especially a discharge lamp of the short arc type which is used for a projector or an exposure device.

### Description of Related Art

In a discharge lamp of the short arc type, generally, an anode and a cathode are disposed opposite one another, spaced a short distance apart, within an arc tube. A metal, such as mercury or the like, is encapsulated within the arc tube.

It is desirable that this encapsulated material be completely vaporized during luminous operation of the lamp and serve as an emission material. However, in practice, at a low temperature part(s) within the arc tube, condensation of the encapsulated emission material often occurs. In this case, the disadvantage arises that sufficient radiation intensity cannot be obtained.

Such low temperature parts occur at the base of the anode and of the cathode, and at a region in which a residual portion of an outlet tube is located. A heat insulating film such as, for example, a finish with a high melting melting point based on aluminum oxide (commercial name in Japan: Okitsumo) or the like is applied to these parts to prevent their temperature from dropping. Merely applying a heat insulating film of this type, however, does not adequately prevent a temperature drop at such parts. Consequently, as before, condensation of the encapsuled emission material occurs.

Furthermore, the disadvantage arises that, during luminous operation, the electrodes wear, and as a result, the inside surface of the arc tube is blackened, and therefore, adverse effects on the illumination maintenance characteristic are produced.

In this case, moreover, it is regarded as disadvantageous that, in a discharge lamp using xenon or mercury as the material the encapsulated emission material, ultraviolet rays with wavelengths of less than or equal to 300 nm are often emitted from the arc tube, producing adverse effects on the working environment of individuals.

### Summary of the Invention

Therefore, a primary object of the invention is to devise a discharge lamp in which a metal or metal compound which condenses at low temperature parts of the arc tube is rapidly vaporized to a sufficient degree, shortening the lamp warm-up time and at the same time, increasing the degree of illumination.

A second object of the invention is to devise a discharge lamp in which a temperature rise within the arc tube results in increased upwardly directed convection, in which material vaporized from the electrodes is able to adhere on the inside of the arc tube outside the utilization angle of the light distribution, and in which blackening of the inside surface of the arc tube can be prevented within the utilization angle of the light distribution.

A third object of the invention is to devise a discharge lamp in which emission of ultraviolet rays with wavelengths of less than or equal to 300 nm does not occur.

These objects and others are achieved according to the invention by the fact that, in a discharge lamp, a arc tube is provided with doping layers for purposes of transmitting visible radiation in accordance with the relationship $8.0 \times 10^{-3} \leq T2/T1 \leq 6.0 \times 10^{-1}$, where T1 is the the thickness of the arc tube in microns ($\mu$m) and T2 is the weight concentration of the doping layers with respect to the weight of the arc tube in parts per million (ppm).

These objects are, furthermore, achieved according to the invention by the fact that a arc tube is provided with doping layers for purposes of transmission of visible radiation in accordance with the relationship $4.35 \leq T1/Q \leq 1000$, where T1 is the thickness of the arc tube in microns and Q is the interior volume of the arc tube in cubic centimeters ($cm^3$).

Additionally, the above objects of the invention are achieved by forming the doping layers in such a way that a arc tube of quartz glass is doped with the following materials:

A : a combination of silicon dioxide ($SiO_2$) and cerium dioxide ($CeO_2$)

B : cerium dioxide ($CeO_2$)

C : a combination of silicon dioxide ($SiO_2$) and titanium dioxide ($TiO_2$)

D: titanium dioxide ($TiO_2$)

The above objects are also achieved according to the invention by the fact that, in the discharge lamp, the outer surface of the arc tube is provided with doped coating layers for purposes of transmission of visible radiation (instead of the arc tube being provided with internal doping layers for purposes of transmission of visible radiation), in accordance with the relationship $8.0 \times 10^{-4} \leq T2/T1 \leq 4.0 \times 10^{-2}$, where T1 is the thickness of the arc tube in microns and T2 is the weight concentration of the doping material within the coating layers in percent (%).

Furthermore, the objects of the invention are achieved by the fact that the coating layers are formed of a combination of silicon dioxide ($SiO_2$) and cerium dioxide ($CeO_2$) and that the dopant material is cerium dioxide ($CeO_2$).

Moreover, the objects according to the invention are achieved by the fact that the coating layers are formed of a combination of silicon dioxide ($SiO_2$) and titanium

dioxide ($TiO_2$) and that the dopant is titanium dioxide ($TiO_2$).

The object of the invention is also achieved by the fact that the outside surface of the arc tube is provided with coating layers for purposes of transmitting visible radiation which are formed of a combination of silicon dioxide ($SiO_2$) and cerium dioxide ($CeO_2$), and that the value of T1/Q is set in the range from 4.35 to 1000, where T1 and Q are defined as indicated above.

In addition, the objects according to the invention are achieved by the fact that the outer surface of the arc tube is provided with coating layers for purposes of transmitting visible radiation which are formed of a combination of silicon dioxide ($SiO_2$) and titanium dioxide ($TiO_2$), and that the value of T1/Q is set in the range from 4.35 to 1000, where T1 and Q are defined as indicated above.

The heat insulation effect can be increased by the discharge lamp according to the invention, first of all, by a measure in which the arc tube is provided with doping layers. Doping layers in conjunction with the thickness of the above described arc tube were established which have a warm-up characteristic and a service life characteristic which can be adequately used for industrial applications and by which, at the same time, radiation wavelengths and the desired radiant exposure density can be obtained.

Furthermore, according to the invention, also by the measure by which the arc tube is provided with coating layers, the heat insulating effect can be increased. The coating layers which have a warm- up characteristic and a service life characteristic which can be adequately used for industrial applications, and by which, at the same time, the desired radiation wavelengths and the desired radiant exposure density can be obtained, as is described above, were established in connection with the thickness of the arc tube.

These and further objects, features and advantages of the present invention will become apparent from the following description when taken in connection with the accompanying drawings which, for purposes of illustration only, show several embodiments in accordance with the present invention.

Brief Description of the Drawings

Fig. 1    shows a discharge lamp according to the invention provided with doping layers;

Fig. 2    graphically depicts the warm-up characteristic of the discharge lamp according to the invention provided with doping layers;

Fig. 3    graphically depicts the service life characteristic of the discharge lamp according to the invention provided with doping layers;

Fig. 4    is a graphic depiction of the radiation wavelengths and the radiant exposure density of the discharge lamp according to the invention provided with doping layers;

Fig. 5    graphically depicts the radiation wavelength and the radiant exposure density of another discharge lamp according to the invention provided with doping layers;

Fig. 6    shows a schematic of the discharge lamp according to the invention provided with coating layers;

Fig. 7    graphically depicts the warm-up characteristic of the discharge lamp according to the invention provided with coating layers;

Fig. 8    is a graphic depiction of the service life characteristic of the discharge lamp according to the invention provided with coating layers;

Fig. 9    graphically depicts the radiation wavelengths and the radiant exposure density of the discharge lamp according to the invention provided with coating layers;

Fig. 10   is a graphic depiction of the radiation wavelengths and the radiant exposure density of another discharge lamp according to the invention provided with coating layers.

Detailed Description of the Preferred Embodiments

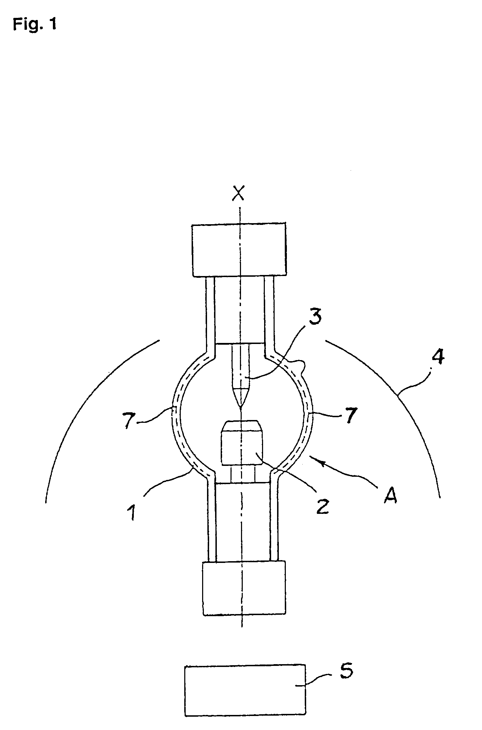

Fig. 1 shows a discharge lamp according to the invention. In the drawing reference number 1 indicates a arc tube made of quartz glass in which a roughly spherical discharge space S is formed. Within the discharge space S, anode 2 and cathode 3 are located opposite one another. A mirror 4 is arranged such that the direction of the arc which is formed near anode 2 and cathode 3 is aligned with the optical axis. Light reflected by mirror 4 is concentrated in a lens 5. In this discharge lamp, for example 45, microliters of mercury and 26600 Pa argon are encapsulated in arc tube 1, and the distance between anode 2 and cathode 3, i.e., the distance between the electrodes, is 3.0 mm. Power is supplied, for example with a nominal voltage of 54 V, nominal current of 13 A and nominal power of 700 W a conventional power source which is not shown in the drawings.

Arc tube 1 has a thickness of, for example, $2,5 \times 10^3$ microns and is uniformly doped over essentially its entire surface area with a material which is made of a combination of silicon dioxide ($SiO_2$) and cerium oxide ($CeO_2$).

In this case, the thickness of arc tube 1 is established in the range of from $1 \times 10^3$ to $5 \times 10^3$ microns. The reason for this is that the arc tube breaks during luminous operation of the lamp when it has a thickness of less than $1 \times 10^3$ microns, due to internal pressure, and that a reduction of the transmission factor of the radiant light occurs at a thickness of greater than $5 \times 10^3$ microns.

The weight concentration, T2, of the doping layers 7 to the weight of the arc tube 1 is, for example, 60 ppm.

Here, according to the invention, the term "arc tube" is defined as the part which encloses the roughly spherical discharge space S. This term does not include hermetically sealed parts which are connected to both ends thereof, except where this is expressly stated. This means that the expression "the arc tube is provided with doping layers for purposes of transmission of visible radiation" specifies that the portion of the tube (quartz glass) which encloses the discharge space S is provided with doping layers for purposes of transmission of visible radiation. Furthermore, the expression "thickness of the arc tube" is defined as the thickness of the tube (quartz glass) in the area enclosing the discharge space S and the expression "weight of the arc tube" is defined as the weight of the part (quartz glass) which encloses the discharge space S with the weights of the quartz glass which forms the hermetically sealed parts, the electrodes and the encapsulation gas not being counted.

Furthermore, the expression "weight concentration of the doping layers to the weight of the arc tube" is defined as the ratio of the weight of the dopant to the total weight of the arc tube together with the weight of the dopant which dopes that part. Moreover, in the case in which part of the arc tube is providing with doping layers, it is the ratio of the weight of the dopant to the total weight of the part of arc tube enclosing the discharge space S together with the weight of the dopant.

The weight concentration of the doping layers to the weight of this arc tube is set in the range from 40 to 600 ppm. The reason for this is that an inadequate heat insulating effect for the arc tube is achieved at a weight concentration of the doping layers to the weight of the entire arc tube of less than 40 ppm, and that uniform formation of doping layers becomes difficult and nonuniformity occurs in the radiant light in the case where this concentration is greater than 600 ppm.

The formation of these doping layers is produced, for example, such that an alcoholate solution of cerium (Ce) and silicon (Si) or the like is applied by an immersion process and is dried at roughly 150° C after air drying, that this process is repeated until layers of silicon dioxide ($SiO_2$) and cerum dioxide ($CeO_2$) with the desired thickness are applied, and that firing of the layers is then performed at roughly 1500 to 2500° C.

Arc tube 1 has an interior volume Q of, for example, 13.35 cm³. The term "interior volume of the arc tube" is defined as the interior volume of the discharge space S after the volumes of the anode and cathode of the arc tube are subtracted, and this volume is set in the range from 10 to 230 cm³. The reason for this is that the load on the wall of the arc tube is increased and breaking of the arc tube is caused when this interior volume is less than 10 cm³, and that proper operation of the lamp cannot be obtained when this interior volume is greater than 230 cm³, since the mercury does not easily vaporize completely.

Consequently, the ratio between the thickness T1 (microns) of the arc tube and the weight concentration T2 (ppm) of the doping layers with respect to the weight of the arc tube is fixed in accordance with the relationship:

$$8.0 \times 10^{-3} \leq T2/T1 \leq 6.0 \times 10^{-1}$$

Furthermore, the ratio T1/Q between the thickness T1 (microns) of the arc tube and the interior volume Q (cm³) of the arc tube is in the range of from 4.35 to 1000.

In this case, the term "dopant" is defined as a material which can transmit visible radiation, i.e., light with wavelengths from 380 to 780 nm.

The doping layers can, furthermore, be applied over the entire area of the arc tube. However, first the inside surface of the arc tube can be doped with the dopants so that it is present thickly in the vicinity of the inside surface bounding the discharge space S.

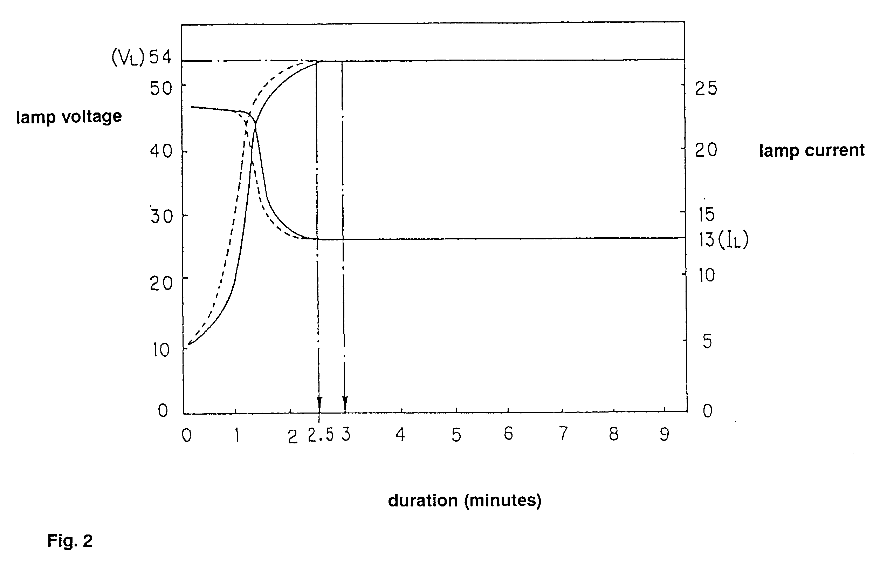

Fig. 2 shows the warm-up characteristics of the discharge lamp in the presence and absence of the doping layers. In the description, the x-axis designates the length of time after start-up of luminous operation of the lamp and the y-axis indicates the luminous voltage and the luminous current of the lamp. In this case, the broken line shows the characteristic of the discharge lamp according to the invention, i.e., the lamp provided with the above stipulated doping layers, and the solid line the characteristics of a discharge lamp in which, for comparison, the low temperature parts of the arc tube have a heat insulating film instead of the provision of doping layers in accordance with the invention.

In this case, as the discharge lamp according to the invention, a lamp was used in which the ratio between the thickness T1 (microns) of the arc tube and the weight concentration T2 (ppm) of the doping layers with respect to the weight of the entire arc tube, i.e., the ration T2/T1, was in the range from $8.0 \times 10^{-3}$ to $6.0 \times 10^1$, and was specifically $6.0 \times 10^{-3}$.

Additionally, the ratio between thickness T1 (microns) of the arc tube and inside volume Q (cm³) of the arc tube, i.e., the value of T1/Q, was in the range from 4.35 to 1000, specifically 190.

It is apparent from the drawing that the conventional lamp represented by the solid line has a stabilization time of the luminous voltage and the luminous current of roughly 3 minutes which conversely in the discharge lamp according to the invention shown using the broken line lasts 2 minutes and 30 seconds. This shows that, according to the invention, a major shortening effect is achieved. The reason for this is that sufficient, and at the same time, rapid vaporization of the mercury encapsulated in the arc tube is achieved.

The same result can be obtained when a combination of silicon dioxide ($SiO_2$) and cerium dioxide ($CeO_2$), cerium dioxide ($CeO_2$), a combination of silicon dioxide ($SiO_2$) and titanium dioxide ($TiO_2$), or titanium dioxide ($TiO_2$) is used as the dopant.

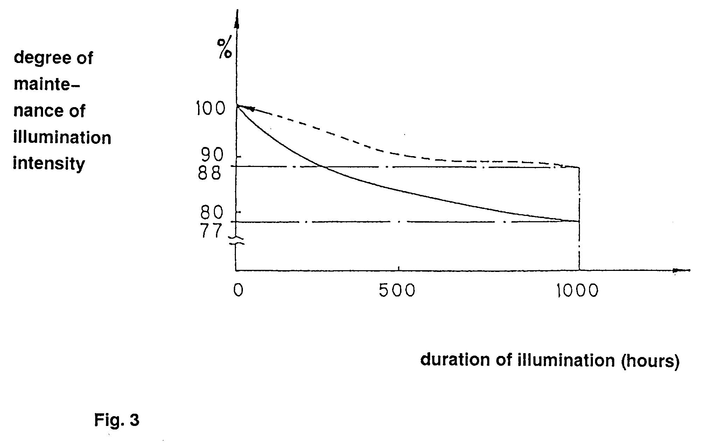

Fig. 3 illustrates the service life characteristic of the discharge lamp depending on the presence or absence of the doping layers. In the drawing, the x-axis designates the length of time after start-up of luminous operation of the lamp and the y-axis the degree of maintenance of the illumination intensity of the radiant light from the lamp. Here, the broken line illustrates the characteristics of the discharge lamp according to the invention, i.e., the lamp provided with the above stipulated doping layers, and the solid line indicates the characteristics of a discharge lamp in which, for comparison, the low temperature parts of the arc tube have a heat insulating film instead of the doping layers according to the present invention.

In this case, as the discharge lamp according to the invention, a lamp was used in which the ratio between the thickness T1 (microns) of the arc tube and the weight concentration T2 (ppm) of the doping layers with respect to the weight of the entire arc tube, i.e., the ratio T2/T1, was in the range from $8.0 - 10^{-3}$ to $6.0 \times 10^{-1}$, and specifically, was $6.0 \times 10^{-3}$. Additionally, the ratio between thickness T1 (microns) of the arc tube and the interior volume Q ($cm^3$) of the arc tube, i.e., the value of T1/Q, was in the range from 4.35 to 1000, and was specifically 190.

The graph of Fig. 3 shows that the illumination intensity after 1000 hours of illumination in a conventional discharge lamp is 77% of its original intensity, while that in the discharge lamp according to the invention maintain an intensity that was 88% of its original intensity. Thus, in the discharge lamp according to the invention, the degree of maintenance of the illumination intensity is roughly 10% higher than the illumination intensity of the conventional discharge lamps. The original light intensity, i.e., that produced immediately after startup of luminous operation, is designated 100% in the figure.

This means that, as the result of increasing the convection directed upwards within the arc tube, the arc tube is prevented from becoming black within the utilization angle of the light distribution.

The same result can be obtained when a combination of silicon dioxide ($SiO_2$) and cerium dioxide ($CeO_2$), cerium dioxide (CeO2), a combination of silicon dioxide ($SiO_2$) and titanium dioxide ($TiO_2$), or titanium dioxide ($TiO_2$) is used as the dopant.

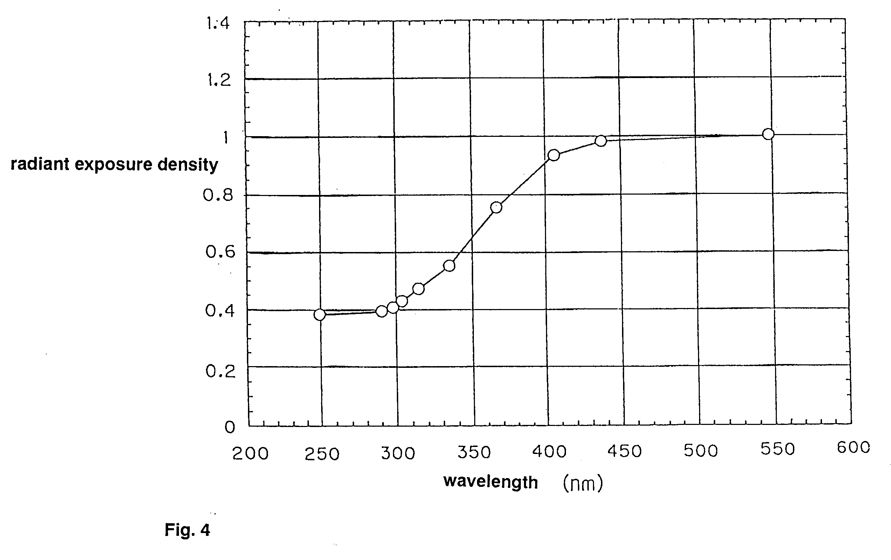

Fig. 4 shows the relationship between the radiation wavelengths and the radiant exposure density of the discharge lamp according to the invention (relative values) in which the x-axis indicates the radiation wavelengths from the lamp and the y-axis indicates the radiant exposure density, and in which the illumination intensity at a wavelength of 550 nm is designated 1.

In the drawing, the characteristic of the discharge lamp according to the invention is shown, i.e., the lamp provided with the above described doping layers. Here, specifically, a lamp was used which was doped with a material formed of a combination of silicon dioxide ($SiO_2$) and and cerium dioxide ($CeO_2$).

In this case, as the discharge lamp according to the invention, a lamp was used in which the ratio between the thickness T1 (microns) of the arc tube and the weight concentration T2 (ppm) of the doping layers with respect to the weight of the entire arc tube, i.e., T2/T1, was set in the range from $8.0 \times 10^{-3}$ to $6.0 \times 10^{-1}$, specifically at $6.0 \times 10^{-3}$, and in which the ratio between thickness T1 (microns) of the arc tube and inside volume Q ($cm^3$) of the arc tube, i.e., the value of T1/Q, was set in the range from 4.35 to 1000, specifically 190.

The plot results show that light with wavelengths of less than or equal to 300 nm is not emitted to a large degree, a significant drop-off in emissions commencing at a wavelength of 400 nm. This is because the ultraviolet rays with short wavelengths are absorbed from the light emitted by the arc tube and the doping layers.

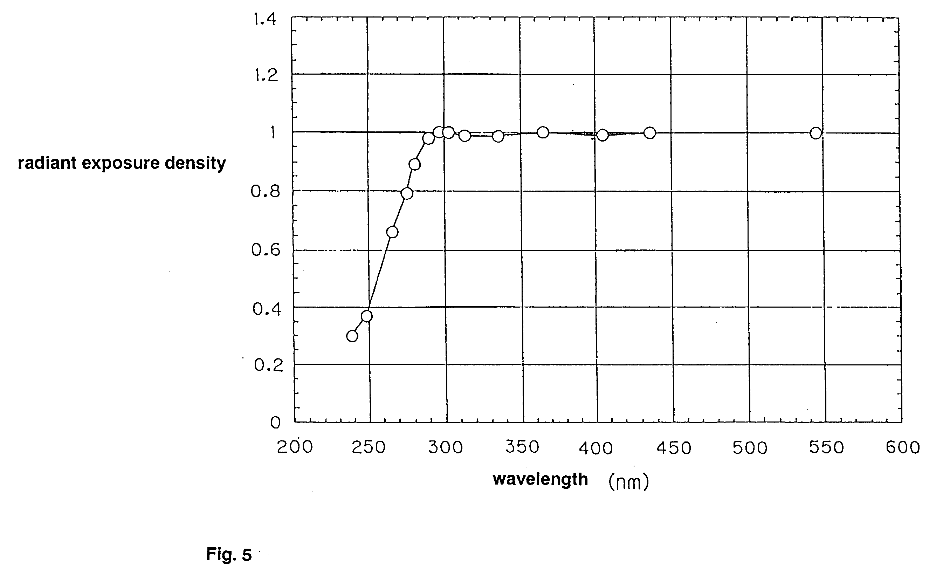

Fig. 5 graphically depicts the relationship between the radiation wavelengths and the radiant exposure density of another discharge lamp according to the invention (relative values) in which the dopant was changed. Here, the x-axis represents the radiation wavelengths from the lamp and the y-axis represents the radiant exposure density, and the ratio when the illumination intensity is at a wavelength of 550 nm is designated 1.

In the drawing, the characteristic of the discharge lamp according to the invention is shown, i.e., the lamp provided with the above stipulated doping layers. Here, specifically, a lamp was used which was doped with a material formed of a combination of titanium dioxide ($TiO_2$) and silicon dioxide ($SiO_2$).

In this case, as the discharge lamp according to the invention, a lamp was used in which the ratio between thickness T1 (microns) of the arc tube and the weight concentration T2 (ppm) of the doping layers with respect to the weight of the entire arc tube, i.e., the ratio T2/T1, was in the range from $8.0 \times 10^{-3}$ to $6.0 \times 10^{-1}$, and specifically, was $6.0 \times 10^{-3}$, and in which the ratio between the thickness T1 (microns) of the arc tube and the interior volume Q ($cm^3$) of the arc tube, i.e., the value of the ratio T1/Q, was in the range form 4.35 to 1000, and specifically, was 190.

Fig. 5 shows that light with wavelengths of less than or equal to 250 nm is not emitted to a large degree, a significant drop-off commencing with emissions at a wavelength of 290 nm. This is because the ultraviolet rays with short wavelengths are absorbed from the light emitted by the arc tube and the doping layers.

As described above, in the discharge lamp according to the invention, the emission of ultraviolet rays can be advantageously suppressed. Therefore, no adverse effects are produced on the working environment, and dullness in the mirror which forms the optical system due to the emission of ultraviolet rays is prevented, even if it is built into an optical device as a light source for purposes of semiconductor exposure.

Furthermore, a discharge lamp according to the invention that is provided with the above stipulated doping, can additionally be provided with a conventional application of the heat insulating film. Specifically, a gold-containing finish as well as a finish with a high melting point based on aluminum dioxide (commercial name in Japan: Okitsumo) can be applied to the nadir of the arc tube.

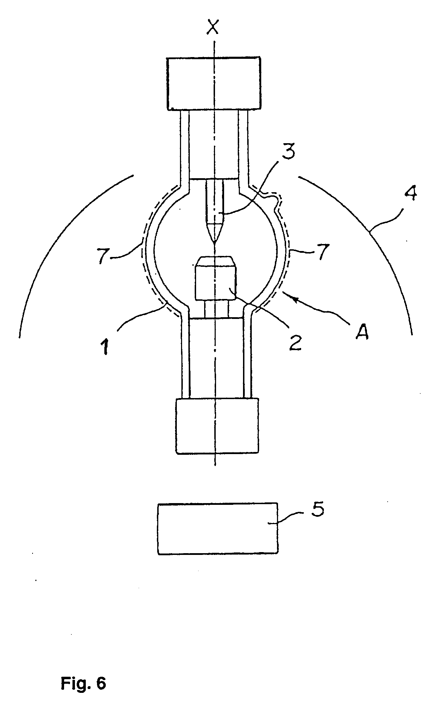

Fig. 6 shows another discharge lamp according to the invention. In this case, coating layers 7 are formed on the outside surface of arc tube 1. These coating layers 7 are formed of a combination of silicon dioxide ($SiO_2$) and cerium dioxide ($CeO_2$). The cerium dioxide ($CeO_2$), as the dopant in these coating layers 7, has a weight concentration T3 of, for example, 15%. Incidentally, this conforms with that of the arrangement shown in Fig. 1.

Here, weight concentration T3 of the dopant in the coating layers is set in the range from 4 to 40%. This is because, in the case of less than 4%, the heat insulating effect hardly occurs. On the other hand, in the case where this percentage is greater than 40%, a uniform formation of the coating layers does not occur, and therefore, uniform light emission cannot be achieved due to the nonuniformity occurring in coating layers 7.

Thickness T1 of the arc tube and interior volume Q of the arc tube are set in the same ranges as in the discharge lamp in which the arc tube is provided with doping layers, i.e., that of Fig. 1.

Based on these conditions, the ratio between thickness T1 (microns) of the arc tube and weight concentration T3 (ppm) of the dopant in the coating layers, i.e., the value of T2/T1, is fixed at $8.0 \times 10^{-4}$ to $4.0 \times 10^{-2}$.

Furthermore, the ratio between thickness T1 (microns) of the arc tube and inside volume Q (cm3) of the arc tube, i.e., the value of T1/Q, is set to be 4.35 to 1000.

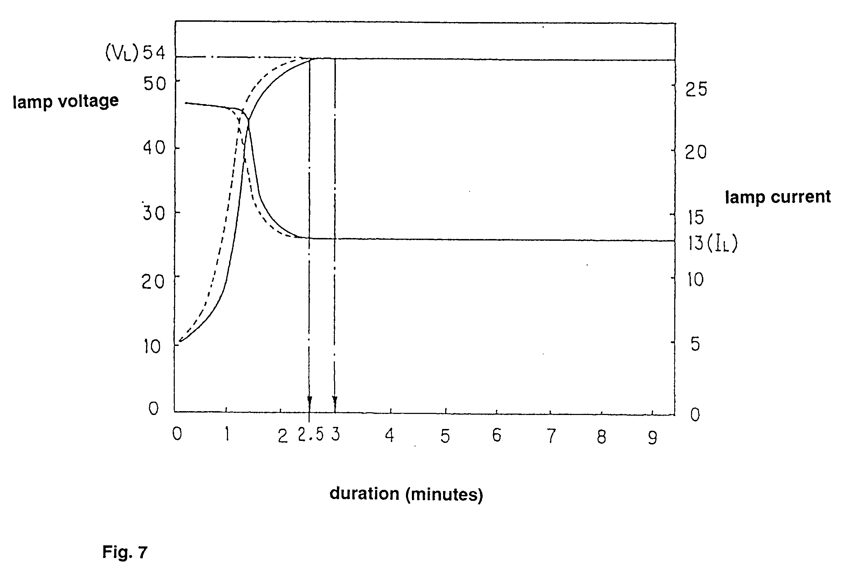

Fig. 7 shows the warm-up characteristics of this discharge lamp depending on the presence or absence of the coating layers. In the figure, the x-axis indicates the length of time after start-up of luminous operation of the lamp and the y-axis indicates the luminous voltage and the luminous current of the lamp.

Here, the broken line shows the characteristics of the discharge lamp according to the invention, i.e., the lamp provided with the above stipulated coating layers, and the solid line shows the characteristics of a discharge lamp in which, for comparison, the low temperature parts of the arc tube are provided with a heat insulating film instead of the coating layers of the present invention.

In this case, as the discharge lamp according to the invention, a lamp was used in which the ratio between the thickness T1 (microns) of the arc tube and the weight concentration T2 (ppm) of the dopant in the coating layers, i.e., T2/T1, was in the range of from $8.0 \times 10^{-4}$ to $4.0 \times 10^{-2}$, specifically 0.024, and in which the ratio between thickness T1 (microns) of the arc tube and interior volume Q (cm3) of the arc tube, i.e., the value of T1/Q, was in the range from 4.35 to 1000, specifically 190.

It is apparent from the figure that the conventional lamp, represented the solid line, has a stabilization time of the luminous voltage VL and the luminous current IL of roughly 3 minutes, which conversely in the discharge lamp according to the invention, shown using the broken line, is 2 minutes and 30 seconds. This shows that the invention achieves a major shortening effect. The reason for this is that sufficient, and at the same, time rapid vaporization of the mercury encapsulated in the arc tube is achieved.

In this test, a combination of silicon dioxide ($SiO_2$) and cerium dioxide ($CeO_2$) was used for the coating layers. However, it is also possible to use coating layers of a material in which titanium dioxide ($TiO_2$) and silicon dioxide ($SiO_2$) are combined.

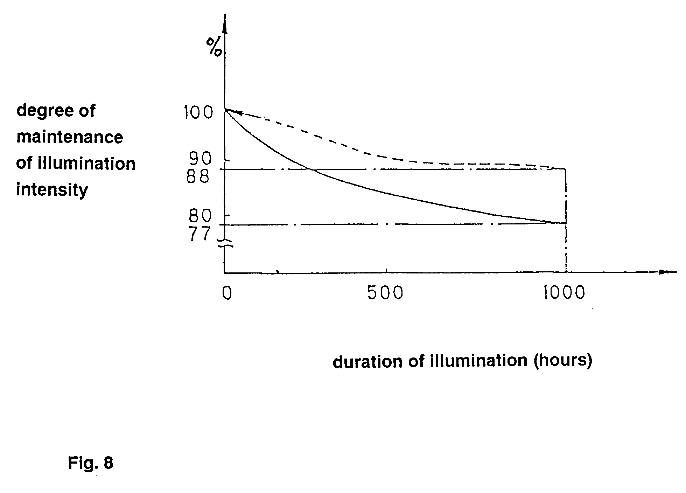

Fig. 8 illustrates the service life characteristics of the discharge lamp depending on the presence or absence of coating layers. In the figure, the x-axis designates the length of time after start-up of luminous operation of the lamp and the y-axis represents the degree of maintenance of the illumination intensity of the radiant light from the lamp. In this case, the broken line shows the characteristic of the discharge lamp according to the invention, i.e., the lamp provided with the above stipulated coating layers, and the solid line indicates the characteristics of a discharge lamp in which, for comparison, the low temperature parts of the arc tube have a heat insulating film and the inventive coating layers are not present.

In this case, as the discharge lamp according to the invention, a lamp was used in which the ratio between the thickness T1 (microns) of the arc tube and the weight concentration T2 (ppm) of the dopant with respect to the coating layers, i.e. T2/T1, was in the range from $8.0 \times 10^{-3}$ to $4.0 \times 10^{-2}$, and specifically was $6.0 \times 10^{-3}$. Additionally, the ratio between the thickness T1 (microns) of the arc tube and interior volume Q (cm3) of the arc tube, i.e., the value of T1/Q, is in the range from 4.35 to 1000, specifically 190.

The drawing shows that the illumination intensity after 1000 hours of illumination in a conventional discharge lamp is 77% of its original value immediately after start-up of luminous operation (represented as 100%), and that in the discharge lamp according to the invention the lumination value is 88% of its original value, achieving a degree of maintenance of the illumination intensity that is roughly 10% higher than that of the conventional discharge lamp.

This means that, as the result of the increase in convection directed upwards within the arc tube, the arc tube is prevented from becoming black within the utilization angle of the light distribution.

In this test, a combination of silicon dioxide ($SiO_2$) and cerium dioxide ($CeO_2$) was used for the coating layers. However, it is also possible to use coating layers of a material in which titanium dioxide ($TiO_2$) and silicon dioxide ($SiO_2$) are combined.

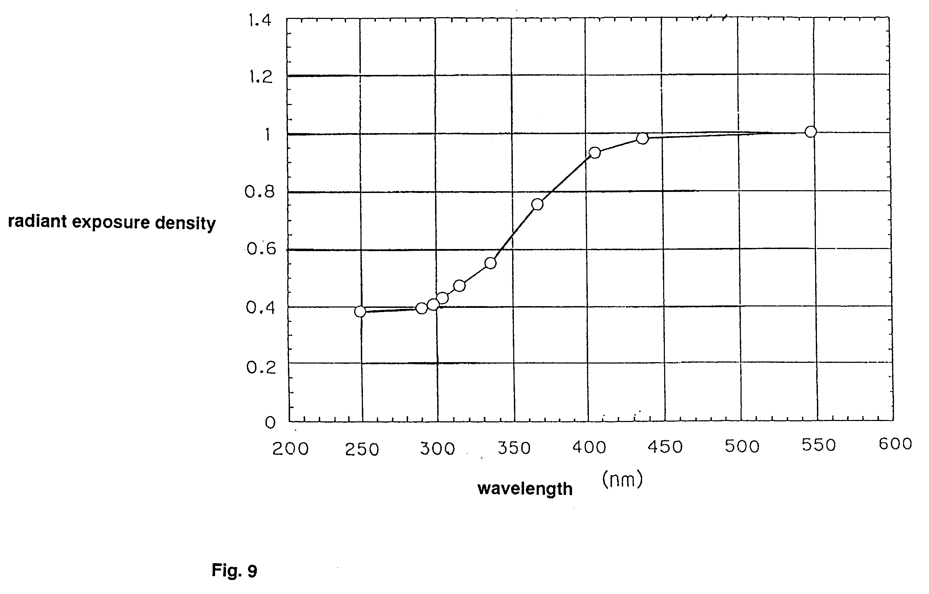

Fig. 9 shows a plot of the relationship between the radiation wavelengths and the radiant exposure density of the discharge lamp according to the invention (relative values). Here, the x-axis indicates the radiation wavelengths from the lamp and the y-axis indicates the radiant exposure density, the ratio when the illumination intensity is at a wavelength of 550 nm being designated 1.

In the figure, the characteristic of the discharge lamp according to the invention is shown, i.e., the lamp provided with the above stipulated coating layers. Here, specifically, a lamp was used which was provided with coating layers formed of a combination of silicon dioxide ($SiO_2$) and cerium dioxide ($CeO_2$).

In this case, as the discharge lamp according to the invention, a lamp was used in which the ratio between thickness T1 (microns) of the arc tube and weight concentration T2 (ppm) of the dopant in the coating layers, i.e., the ratio T2/T1, was in the range from $8.0 \times 10^{-4}$ to $4.0 \times 10^{-2}$, specifically $6.0 \times 10^{-3}$, and in which the ratio between thickness T1 (microns) of the arc tube and inside volume Q ($cm^3$) of the arc tube, i.e., the value of T1/Q, was in the range from 4.35 to 1000, specifically 190.

Fig. 9 shows that light with wavelengths of less than or equal to 300 nm is not emitted to a large degree, a substantial drop-off in emissions commencing at a wavelength of 400 nm. This is because the ultraviolet rays with short wavelengths are absorbed from the light emitted by the arc tube and the coating layers.

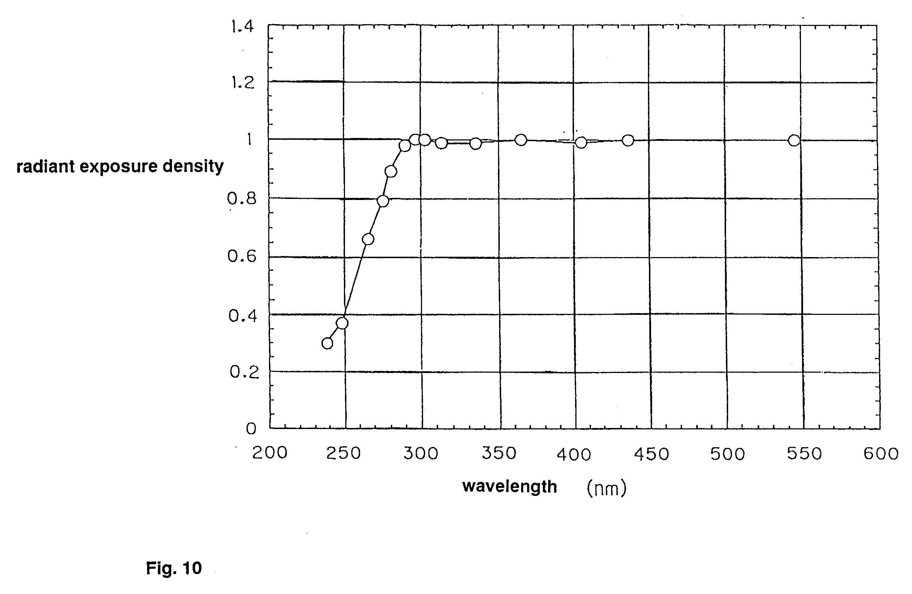

Fig. 10 shows a plot of the ratio between the radiation wavelengths and the radiant exposure density of another discharge lamp according to the invention (relative values) in which the dopant was changed. Here, the x-axis represents the radiation wavelengths from the lamp and the y-axis represents the radiant exposure density, the ratio when the illumination intensity is at a wavelength of 550 nm being designated 1.

In the figure, the characteristics of the discharge lamp according to the invention, i.e., the lamp provided with the above stipulated coating layers, are shown. Here, specifically, a lamp was used which was provided with a coating material formed of a combination of titanium dioxide ($TiO_2$) and silicon dioxide ($SiO_2$).

In this case, as the discharge lamp according to the invention, a lamp was used in which the ratio between thickness T1 (microns) of the arc tube and weight concentration T2 (ppm) of the coating layers with respect to the weight of the entire arc tube, i.e., the ratio T2/T1, was in the range from $8.0 \times 10^{-4}$ to $4.0 \times 10^{-2}$, specifically $6.0 \times 10^{-3}$, and in which the ratio between thickness T1 (microns) of the arc tube and inside volume Q ($cm^3$) of the fluorescent tube, i.e., the value of T1/Q, was in the range from 4.35 to 1000, specifically 190.

Fig. 10 shows that light with wavelengths of less than or equal to 250 nm is not emitted to a large degree, a substantial drop-off in emissions commencing at a wavelength of 290 nm. This is because the ultraviolet rays with short wavelengths are absorbed from the light emitted by the arc tube and the coating layers.

As described above, in the discharge lamp according to the invention, the emission of ultraviolet rays can be advantageously suppressed. Therefore, no adverse effects are produced on the working environment due to the emission of ultraviolet rays and dullness in the mirror which forms the optical system due to ultraviolet rays is prevented, even if the mirror is built into an optical device as a light source for purposes of semiconductor exposure.

Furthermore, for the discharge lamp according to the invention which was provided with the above described coating, conventional application of the heat insulating film can be used in addition. Specifically, gold-containing finish as well as a finish with a high melting point based on aluminum dioxide (commercial name in Japan: Okitsumo) can be applied to the nadir of the arc tube.

It is to be understood that although preferred embodiments of the invention have been described, various other embodiments and variations may occur to those skilled in the art. Any such other embodiments and variations which fall within the scope and spirit of the present invention are intended to be covered by the following claims.

## Claims

1. Discharge lamp comprising an arc tube with doping layers for purposes of transmission of visible radiation, wherein a value of a ratio T2/T1 is set in a range from $8.0 \times 10^{-3}$ to $6.0 \times 10^{-1}$,
   where T1 is a thickness of the arc tube in microns and T2 is a weight ratio of dopant in said doping layers with respect to the weight of the arc tube in parts per million.

2. Discharge lamp according to claim 1, wherein the said dopant is a material selected from the group consisting of one of the following materials:

   A :      a combination of silicon dioxide ($SiO_2$) and cerium dioxide ($CeO_2$);

   B :      cerium dioxide ($CeO_2$);

   C :      a combination of silicon dioxide ($SiO_2$) and titanium dioxide ($TiO_2$); or

   D:      titanium dioxide ($TiO_2$).

3. Discharge lamp according to claim 1, wherein a value of a ratio T1/Q is set in a range of from 4.35 to 1000, where Q is an interior volume of the arc tube in $cm^3$.

4. Discharge lamp according to claim 3, wherein the dopant consists of a material selected from the group consisting of one of the following materials:

   A :      a combination of silicon dioxide ($SiO_2$) and cerium dioxide ($CeO_2$);

   B :      cerium dioxide ($CeO_2$);

   C :      a combination of silicon dioxide ($SiO_2$) and titanium dioxide ($TiO_2$); or

D:    titanium dioxide (TiO$_2$).

5.  Discharge lamp comprising a arc tube provided with doping layers for purposes of transmission of visible radiation, wherein a value of a ratio T1/Q is set in a range from 4.35 to 1000, where T1 is a thickness of the arc tube in microns and where Q is an interior volume of the arc tube in cm$^3$.

6.  Discharge lamp according to claim 5, wherein the dopant consists of a material selected from the group consisting of one of the following materials:

    A :    a combination of silicon dioxide (SiO$_2$) and cerium dioxide (CeO$_2$);

    B :    cerium dioxide (CeO$_2$);

    C :    a combination of silicon dioxide (SiO$_2$) and titanium dioxide (TiO$_2$); or

    D:    titanium dioxide (TiO$_2$).

7.  Discharge lamp comprising a arc tube having an outside surface provided with coating layers for purposes of transmitting visible radiation, and wherein a ratio T2/T1 is set at a value in a range of from $8.0 \times 10^{-4}$ to $4.0 \times 10^{-2}$, where T1 is a thickness of the arc tube in microns and T2 is a weight concentration of a dopant in the coating layers.

8.  Discharge lamp according to claim 7, wherein the coating layers are formed of a combination of silicon dioxide (SiO$_2$) and cerium dioxide (CeO$_2$) and the dopant is cerium dioxide (CeO$_2$).

9.  Discharge lamp according to claim 7, wherein the coating layers are formed of a combination of silicon dioxide (SiO$_2$) and titanium dioxide (TiO$_2$) and the dopant is titanium dioxide (TiO$_2$).

10. Discharge lamp comprising an arc tube having an outside surface provided with coating layers for purposes of transmitting visible radiation, said coating layers comprising a combination of silicon dioxide (SiO$_2$) and cerium dioxide (CeO$_2$), and wherein a ratio T1/Q is set at a value in a range of from 4.35 to 1000, where T1 is a thickness of the arc tube in microns and Q is an interior volume of the arc tube in cm$^3$.

11. Discharge lamp comprising a arc tube having an outside surface provided with coating layers for purposes of transmitting visible radiation, said coating layers comprising a combination of silicon dioxide (SiO$_2$) and titanium dioxide (TiO$_2$), and wherein a ratio of T1/Q is set at a value in a range of from 4.35 to 1000, where T1 is a thickness of the arc tube in microns and Q is an interior volume of the arc tube in cm3.

**Fig. 1**

Fig. 2

EP 0 704 881 A2

Fig. 3

Fig. 4

Fig. 5

EP 0 704 881 A2

Fig. 6

Fig. 7

degree of
maintenance
of illumination
intensity

%

100

90
88

80
77

0

500

1000

duration of illumination (hours)

Fig. 8

Fig. 9

Fig. 10